# EUROPEAN PATENT SPECIFICATION

(11) **EP 0 858 680 B1**
(45) Date of publication and mention of the grant of the patent: **15.10.2003**
(21) Application number: 97939525.8
(22) Date of filing: 22.08.1997
(51) Int. Cl.: H01P 5/107, H01P 1/22

(54) **INTEGRATED EVANESCENT MODE FILTER WITH ADJUSTABLE ATTENUATOR**
MIT EINSTELLBAREM DÄMPFUNGSGLIED INTEGRIERTES GRENZFREQUENZFILTER
FILTRE A MODE EVANESCENT INTEGRE AVEC ATTENUATEUR REGLABLE

(30) Priority: 03.09.1996 US 707277
(43) Date of publication of application: 19.08.1998
(73) Proprietor: Raytheon Company, El Segundo, California 90245 (US)
(72) Inventor: PAUL, Jeffrey, A., Torrance, CA 90501 (US); WARZMAN, Chaim, Torrance, CA 90505 (US); WIEN, Roy, Cerritos, CA 90703 (US); HENNEGAN, Richard, T., Redondo Beach, CA 90278 (US)
(74) Representative: Lindner, Michael, Dipl.-Ing.
(86) International application number: PCT/US97/14856
(87) International publication number: WO 98/010481

(56) References cited:
- US-A- 3 209 288
- US-A- 3 958 194
- US-A- 4 716 387
- US-A- 4 803 446
- US-A- 4 994 775
- US-A- 5 202 648
- M.N. BERGER ET AL.: "A BEYOND-CUTOFF WAVEGUIDE-DIELECTRIC FILTER USING MICROSTRIP LINES " TELECOMMUNICATIONS AND RADIO ENGINEERING., vol. 34/35, no. 6, June 1980, NEW YORK, NY US, pages 95-97, XP002046339

## Description

### BACKGROUND OF THE INVENTION

### Field of the Invention

This invention relates to a waveguide evanescent mode filter with an integrated adjustable attenuator that is compatible for integration on a monolithic microwave integrated circuit (MMIC) module, and particularly to a monolithic microwave-integrated circuit module comprising a conductive ground plane ; MMIG circuitry on said ground plane; a waveguide and signal connections between said waveguide and said MMIC circuitry.

### Description of the Related Art

Waveguide filters can readily achieve low passband insertion loss and high out-of-band rejection, which are characteristics desirable in a filter. It is known that a waveguide has a cutoff frequency below which a signal cannot propagate through the waveguide. For a rectangular waveguide having a width (a), attenuation of the waveguide at a frequency below the cutoff frequency is characterized by the following equation:$\text{α=} \frac{\text{π}}{\text{a}} \sqrt{\text{1-(} \frac{\text{f}}{{\text{f}}_{\text{c}}} {\text{)}}^{\text{2}}}$ where α=attenuation in nepers/meter, a=width of waveguide, f=frequency, f_{c}=cutoff frequency=(c/2a) for the TE₁₀ mode, where c is the speed of electromagnetic wave propagation. This waveguide characteristic for a frequency below cutoff is called an evanescent mode, and is described in S. Ramo et al., Fields and waves in Communication Electronics, John Wiley & Sons, Inc., 2nd ed., 1984, pages 444-446.

With this characteristic of the waveguide, a high pass filter can be realized by progressively narrowing the width of the rectangular waveguide to eliminate undesirable low frequency signals and allow high frequency signals to pass through the waveguide. This filter is called an evanescent mode filter.

A thin resistive card may be inserted into the waveguide from a slot opening in one of the broad walls of the waveguide to form an adjustable- attenuator, as described in R.E. Collin, Foundations for Microwave Engineering, McGraw-Hill, Inc., 1966, page 262. The amount of attenuation can be controlled by adjusting the penetration depth of the card. The attenuator provides attenuation for all frequencies passing through the waveguide.

At microwave and millimeter wave frequencies, passive devices on a MMIC module are typically microstrip or stripline circuit devices, including filters and attenuators. Examples of microstrip or stripline filters for MMIC applications are described in Patent No. US 5,485,131 and Patent No. US 5,319,329. Filters realized in microstrip and stripline circuits generally have high passband insertion loss and poor out-of-band rejection skirts compared to those of a waveguide filter.

Microstrip and stripline circuits exhibit transverse electromagnetic (TEM) field patterns, and passive variable components are difficult to realize in TEM circuits. Variable attenuators have been realized in MMIC circuits by using field-effect transistor (FET) circuits, as disclosed in Patent No. US 4,837,530, Patent No. US 4,875,023, Patent No. US 4,890,077, Patent No. US 4,996,504, and Patent No. US 5,309,048. However, these circuits are complicated and require active components, i.e., FETs. Variable attenuators using purely passive means are difficult to implement in a microstrip or stripline circuit.

In a conventional MMIC module for millimeter wave applications, separate assemblies were required for a filter and an adjustable attenuator, resulting in larger volume, more weight, and higher cost.

US 4,716,387 discloses a waveguide-microstrip line converter to be used in combination with a waveguide, for mode conversion in transmitting a signal from the waveguide to a microstrip line. This document further discloses a band-pass filter incorporating the waveguide-microstrip line converters. A plurality of waveguide resonators packed with a dielectric are connected and a pair of waveguides packed with a dielectric are disposed at the opposite ends of the array of waveguide resonators, respectively. A pair of the waveguide-microstrip line converters are disposed on the outer side of the waveguides and are connected to the microstrip lines provided on a MIC substrate.

US 4,803,446 discloses a low noise microwave amplifier wherein a length of a pair of broad or wider walls inside a rectangular waveguide is shortened at least near a portion where a probe for introducing a microwave signal into the amplifying portion is provided.

US 5,202,648 discloses a waveguide-to-microstrip transition module transmitting captured electromagnetic energy between a waveguide and signal processing circuitry.

US 3,209,288 discloses a waveguide comprising means for variably inserting a portion of a substrate of dielectric material in order to attenuate the microwave energy conducted in the waveguide.

US 4,994,775 discloses a low loss high-pass microwave filter for microstrip circuits. The microwave filter comprises a single-ridge waveguide which is attached to a microstrip circuit in a manner to establish a cut-off frequency of the circuit.

US 3,958,194 discloses a waveguide attenuator which may be used in a dominant-mode waveguide.

The paper "A beyond-cutoff waveguide-dielectric filter using microstrip lines", M.N. Berger et al., telecommunications and radio engineering, vol 34/35, no. 6. Juni 1980, pages 95-97, discloses a waveguide mounted on a substrate which is also provided with a microstrip line. The waveguide shown has a rectangular form and a plane dielectric layer.

### SUMMARY OF THE INVENTION

In view of the difficulties of microstrip and stripline microwave and millimeter wave circuits in realizing a filter with satisfactory frequency responses and a feasible adjustable attenuator, the present invention provides a combined waveguide filter and attenuator device that is compatible for integration on a MMIC circuit.

The invention is defined by the appended claims.

This invention allows a waveguide filter with an adjustable attenuator to be manufactured on a MMIC module, using low cost techniques such as die casting or metallized injection molded plastics, yet provides a filter performance and attenuator adjustability that is matched only by separate waveguide filters and adjustable attenuators. Compared to separate waveguide filters and attenuators, the integrated filter/attenuator realized in this invention is physically smaller and less expensive to implement, and is therefore suitable for commercial applications such as communications and automotive electronics.

In a preferred embodiment, the E-plane, which is the plane along the width of the waveguide, is centered about a flat ground plane, with a single cover section that includes a plurality of impedance transformers as the filter section. This allows one wall of the waveguide to be opened up to accept a thin resistive card, which attenuates the signals passing through the center waveguide section. The penetration of the card into the waveguide is adjustable by moving the card from outside the waveguide thereby providing variable attenuation to the signals.

These and other features and advantages of the invention will be apparent to those skilled in the art from the following detailed description, taken together with the accompanying drawings, in which:

### BRIEF DESCRIPTION OF THE DRAWINGS

FIG. 1 is a plan view of a MMIC module which has a filter/attenuator top assembly with probe couplings at the input and the output of the filter in accordance with the invention;
FIG. 2 is a sectional view taken along the section line 2-2 of FIG. 1, showing step variations in the recessed ground plane and top assembly portions of the waveguide;
FIG. 3 is a sectional view of another embodiment similar to FIG. 2, but with step variations only in the top assembly portion of the waveguide;
FIG. 4 is a sectional view of another embodiment similar to FIGs. 2 and 3, but with tapered variations in the top assembly portion of the waveguide;
FIG. 5 is an end sectional view taken along the section line 5-5 of FIG. 1, showing the ends of the waveguide in the embodiments of FIGs. 2, 3, and 4.

### DETAILED DESCRIPTION OF THE INVENTION

The present invention provides an integrated waveguide filter and attenuator that is easily fabricated on a monolithic microwave integrated circuit (MMIC) module with good performance, low cost, and high yield in manufacturing.

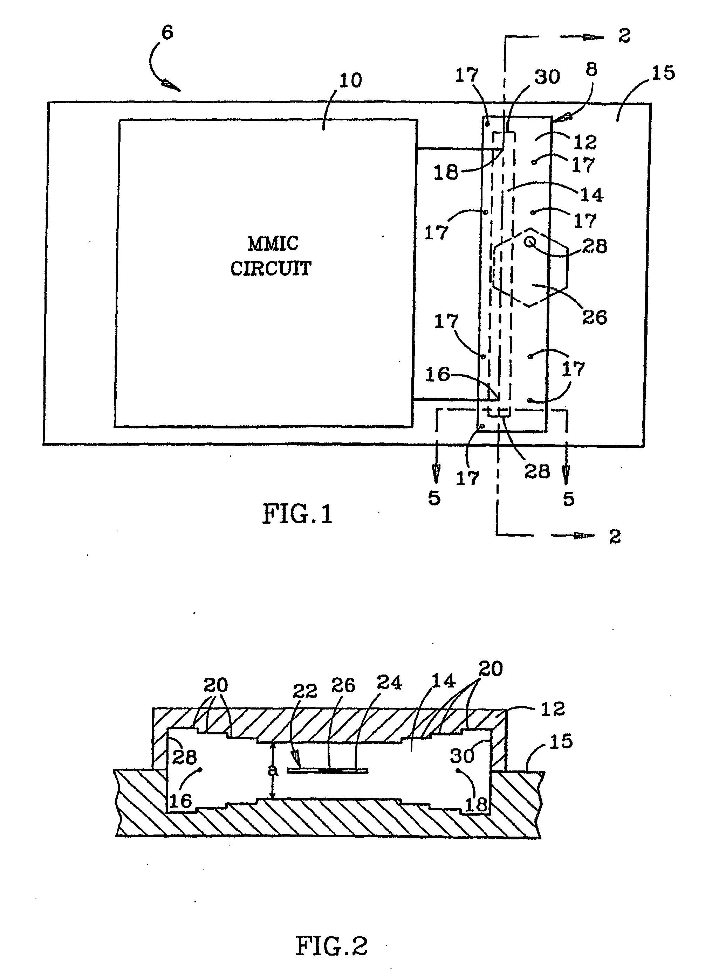

FIG. 1 shows a MMIC module 6 upon which a filter/attenuator 8 and other parts of a MMIC circuit 10 are integrated. The filter/attenuator 8 has a top assembly 12 which covers a waveguide 14. The top assembly 12 is preferably fastened to a ground plane 15 of the MMIC module 6 by a plurality of screws 17. The waveguide 14 has a hollow interior surrounded by conductive walls and is defined by the top assembly 12 and the ground plane 15. The waveguide 14 has an input coupling probe 16 near one end for receiving microwaves, and an output coupling probe 18 near the other end for transmitting filtered and/or attenuated waves.

The waveguide 14 includes a plurality of impedance transformers 20, which are variations in the width of the waveguide 14 along its length, shown in FIG. 2. When the waveguide is used for a high pass filter, the waveguide's width narrows beyond the input coupling to reject input microwave frequencies below the cutoff frequency. The cutoff frequency f_{c} of the TE₁₀ mode of a rectangular waveguide is determined by the width (a) of the waveguide by the relationship${\text{f}}_{\text{c}} \text{=} \frac{\text{c}}{\text{2} \text{a}}$ where c is the speed of electromagnetic wave propagation. For a rectangular waveguide, TE₁₀ mode is the dominant mode of propagation and has the lowest cutoff frequency.

At frequencies below the cutoff frequency, input signals attenuate and do not propagate through the waveguide. The attenuation within a rectangular waveguide below cutoff frequency is characterized by equation (1) given previously.

A high pass filter is realized by decreasing the width of the waveguide 14. For low cost and reliable manufacture of the filter, it is preferred that the waveguide cross-section be abruptly changed at discrete locations along its length. In a preferred embodiment, a plurality of step impedance transformers 20 are implemented along the length of the waveguide 14. Each of the transformers 20 has a length of approximately one-quarter wavelength between adjacent step discontinuities for impedance matching. Preferably, the transformers are formed by machining the top assembly 12 and the ground plane 15 using the techniques of electrodynamic machining, casting or stamping. The narrowest width (a) of the waveguide determines the cutoff frequency f_{c} of the filter. A section 22 of the waveguide has a slot opening 24 for receiving a thin resistor card 26 that penetrates into the interior of the section 22. The slot opening 24 is preferably flush with the top surface of the ground plane 15. The resistor card 26 acts as a variable attenuator that attenuates signals of all frequencies traveling through the waveguide. The resistive card 26 is preferably made of a high-resistance material such as carbon. The resistor card 26 is movable so that its penetration into the waveguide is adjustable. In a preferred embodiment, one end of the resistor card 26 is held by a pivot 28 and is rotatable about the pivot 28. The resistor card 26 is adjusted by manually rotating it, and is held in place by the frictional force between the pivot 28 and the resistor card 26. The attenuation of all signal frequencies in the waveguide increases as the resistor card 26 penetrates deeper into the waveguide section 22.

The waveguide may have many different cross-sectional shapes, such as rectangular, circular, elliptical or oblong. For easy manufacturing of the waveguide on a MMIC module using techniques such as die casting or metallized injection molded plastics, it preferably has a rectangular cross-section.

Coupling of microwave energy into and out of the waveguide 14 are achieved by the input probe 16 and the output probe 18 respectively. The probes 16 and 18 are conductive transmission line segments that partially penetrate into the broad wall of the waveguide 22, near the short-circuit ends 28 and 30 of the waveguide. Because the integrated filter with adjustable attenuator has a substantially symmetrical side cross-section, the input and output of the device is interchangeable in operation.

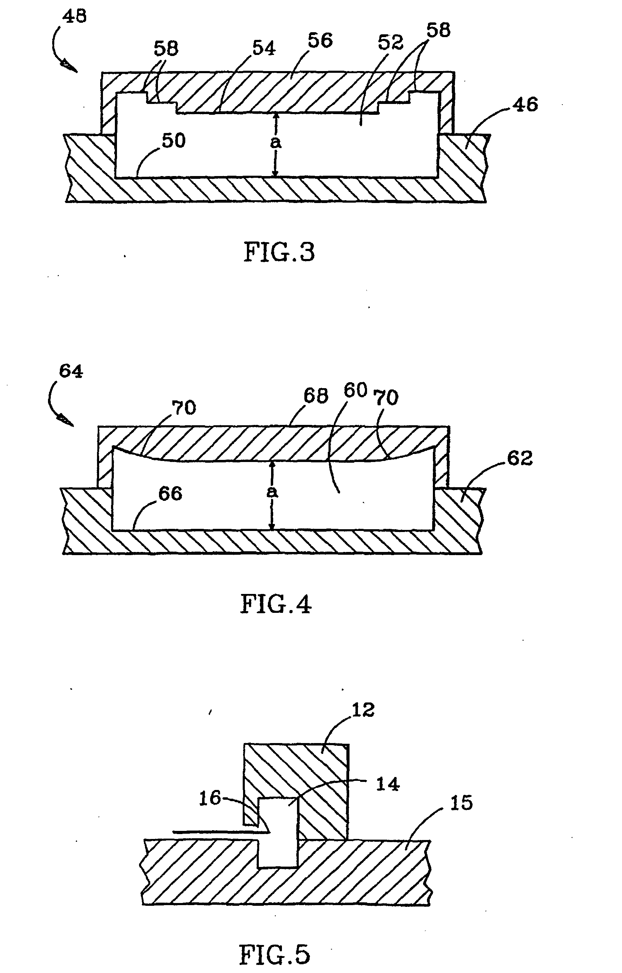

In a preferred embodiment, shown in FIG. 3, the ground plane 46 of a MMIC module 48 has a recess 50 which forms a portion of waveguide 52, but the recessed portion 50 is flat throughout the length of the waveguide and does not contain step discontinuities. In the top waveguide portion 54 defined by top assembly 56, a series of step transformers 58 each having a length of approximately one-quarter wavelength are formed by abrupt changes at discrete locations only in the top assembly portion 54 of the waveguide 52. Because the ground plane 46 of the MMIC module 48 has one flat rectangular recess without any variations in the depth of the recess, this configuration enables low cost and high yield manufacturing of the filter/attenuator device.

In another configuration, shown in FIG. 4, the step transformers of FIGs. 2 and 3 are replaced by a tapered variation in the width of the waveguide 60 along its length. The ground plane 62 of the MMIC module 64 has a flat rectangular recess 66 to form the lower portion of the waveguide 60. The top assembly 68 provides the top portion of the waveguide 60 and has tapered transitions 70 from the two ends of the waveguide 60 to the center. The narrowest width (a) in the waveguide determines its cutoff frequency.

Many possible configurations exist for coupling microwave energy into and out of the waveguide filter and attenuator device. In a preferred embodiment that facilitates implementation of input and output couplings in a waveguide on a MMIC module, probes are used to couple energy into and out of the device. In FIG. 5, the ground plane 15 is partially recessed and is aligned with the top assembly 12 to form a rectangular waveguide 14. The MMIC probe 16, which is a conductive transmission line segment extended from a stripline or a microstrip, penetrates partially into the waveguide 14. The length of the probe penetration and the distance of the probe 16 from the waveguide's short-circuit end 28 are precisely determined to minimize reflection and losses when microwave energy is coupled into or out of the waveguide 14 through the probe 16.

## Claims

1. A monolithic microwave integrated circuit (MMIC) module (6; 48; 64), comprising:
a conductive ground plane (15; 46; 62);
MMIC circuitry (10) on said ground plane (15; 46; 62);
a waveguide (14; 52; 60); and
signal connections between said waveguide (14; 52; 60) and said MMIC circuitry (10), wherein said waveguide (14; 52; 60) has a transverse cross-section and extends in a longitudinal direction on said ground plane (15; 46; 62), said waveguide (14; 52; 60) including a plurality of variations in its transverse cross-sectional dimension along the longitudinal direction, the smallest cross-section (a) determining the waveguide's cutoff frequency below which electromagnetic waves are supressed in amplitude, **characterized by**
an adjustable attenuator (22) positioned to adjustably attenuate electromagnetic waves propagating through said waveguide (14; 52; 60).

2. The module of claim 1, **characterized in that** said transverse cross-section has a rectangular shape.

3. A module as in one of the claims 1-2, **characterized in that** said signal connections further comprise two probes (16, 18) positioned to couple said electromagnetic waves into and out of said waveguide (14; 52; 60), each probe (16, 18) penetrating into said waveguide (14; 52; 60) and having a penetration length and location precisely determined to minimize insertion losses.

4. A module as in one of the claims 1-3, **characterized in that** said variations in the transverse cross-section of said waveguide (14; 52) comprise a plurality of step impedance transformers (20; 58) formed by abrupt changes in the transverse cross-sectional dimension along the longitudinal dimension of said waveguide (14; 52).

5. The module of claim 4, **characterized in that** said waveguide (14; 52; 60) is defined by a recess (50; 66) in the ground plane (15; 46; 62) and a top assembly (12; 56) having a recess, each of said recesses having a plurality of abrupt changes in their depths to form said plurality of step impedance transformers (20).

6. The module of claim 4, **characterized in that** said waveguide (52) is defined by a recess (50) in the ground plane (46) and a top assembly (56) having a recess (54), said ground plane recess (50) having a substantially constant depth and said top assembly recess (54) having a plurality of abrupt changes in its depth of the recess to form said plurality of step impedance transformers (58).

7. A module as in one of claims 1-3, **characterized in that** said variations in the transverse cross-section of said waveguide (60) comprise continuous changes in the transverse cross-sectional dimension.

8. The module of claim 7, **characterized in that** said waveguide (60) is defined by a recess (66) in the ground plane (62) and a top assembly (68) having a recess (70), said ground plane recess (62) having a substantially constant depth and said top assembly (70) recess having continuous changes in the depth of the recess (70) to form said variations in the transverse cross-section.

9. The module of claim 1, **characterized in that** said adjustable attenuator (22) further comprises an opening (24) in said waveguide (14; 52; 60) adapted to accept a resistive card (26) that is movable to allow variable penetration depth of said card (26) into said waveguide (14; 52; 60), whereby said variable penetration depth determines the amount of attenuation in said adjustable attenuator (22).

## Patentansprüche

1. Integriertes monolithisches Mikrowellenschaltungs-(MMIC)-Modul (6; 48; 64), mit:
einer leitenden Masseebene (15; 46; 62);
einer MMIC-Schaltung (10) auf der Masseebene (15; 46; 62);
einem Wellenleiter (14; 52; 60); und
Signalverbindungen zwischen dem Wellenleiter (14; 52; 60) und der MMIC-Schaltung (10), wobei der Wellenleiter (14; 52; 60) einen transversalen Querschnitt besitzt und sich in einer Längsrichtung auf der Masseebene (15; 46; 62) erstreckt, wobei der Wellenleiter (14; 52; 60) eine Vielzahl von Variationen in Richtung des transversalen Querschnitts entlang der Längsrichtung besitzt, wobei der kleinste Querschnitt (a) die Grenzfrequenz des Wellenleiters definiert, unterhalb der elektromagnetische Wellen in ihrer Amplitude unterdrückt werden, **gekennzeichnet durch**
ein einstellbares Dämpfungsglied (22), das angeordnet ist, um die elektromagnetischen Wellen einstellbar zu dämpfen, die sich **durch** den Wellenleiter (14; 52; 60) fortpflanzen.

2. Modul nach Anspruch 1, **dadurch gekennzeichnet, dass** der transversale Querschnitt eine Rechteckform hat.

3. Modul nach einem der Ansprüche 1 - 2, **dadurch gekennzeichnet, dass** die Signalverbindungen ferner zwei Sonden (16, 18) aufweisen, die positioniert sind, um elektromagnetische Wellen in und aus dem Wellenleiter (14; 52; 60) zu koppeln, wobei jede Sonde (16, 18) in den Wellenleiter (14; 52; 60) eindringt und eine Eindringtiefe und Position besitzt, die präzise festgelegt ist, um die Einführverluste zu minimieren.

4. Modul nach einem der Ansprüche 1 - 3, **dadurch gekennzeichnet, dass** die Veränderungen im transversalen Querschnitt des Wellenleiters (14; 52) eine Vielzahl von Stufen-Impedanzumformern (20; 58) aufweisen, die als abrupte Veränderungen der Abmessung des transversalen Querschnitts entlang der Längsabmessung des Wellenleiters (40; 53) ausgebildet sind.

5. Modul nach Anspruch 4, **dadurch gekennzeichnet, dass** der Wellenleiter (14; 52; 60) als Vertiefung (50; 66) in der Masseebene (15; 46; 62) und einer oberen Anordnung (12; .56) ausgebildet ist, die eine Vertiefung besitzt, wobei jede der Vertiefungen eine Vielzahl von abrupten Änderungen ihrer Tiefe aufweisen, um die Vielzahl von Stufen-Impedanzumformern (20) auszubilden.

6. Modul nach Anspruch 4, **dadurch gekennzeichnet, dass** der Wellenleiter (52) durch eine Vertiefung (50) in der Masseebene (46) und einer oberen Anordnung (56) mit einer Vertiefung (54) ausgebildet ist, wobei die Vertiefung (50) der Masseebene eine im Wesentlichen konstante Tiefe aufweist und die Vertiefung der oberen Anordnung (54) eine Vielzahl von abrupten Änderungen der Tiefe der Vertiefung aufweist, um die Vielzahl von Stufen-Impedanzumformern (58) auszubilden.

7. Modul nach einem der Ansprüche 1 - 3, **dadurch gekennzeichnet, dass** die Variationen des transversalen Querschnitts des Wellenleiters (60) kontinuierliche Veränderungen der transversalen Querschnitts-Abmessung umfassen.

8. Modul nach Anspruch 7, **dadurch gekennzeichnet, dass** der Wellenleiter (60) durch eine Vertiefung (66) in der Masseebene (62) und eine obere Anordnung (68) mit einer Vertiefung (70) gebildet wird, wobei die Vertiefung (62) der Masseebene eine im Wesentlichen konstante Tiefe besitzt und die Vertiefung (70) der oberen Anordnung kontinuierliche Veränderungen der Tiefe der Vertiefung (70) umfassen, um die Variationen des transversalen Querschnitts zu bilden.

9. Modul nach Anspruch 1, **dadurch gekennzeichnet, dass** das einstellbare Dämpfungsglied (22) ferner eine Öffnung (24) in dem Wellenleiter (14; 52; 60) umfasst, die angepasst ist, um eine Widerstandskarte (26) zu akzeptieren, die bewegbar ist, um eine variable Eindringtiefe der Karte (26) in den Wellenleiter (14; 52; 60) zu ermöglichen, wobei die variable Eindringtiefe den Betrag der Dämpfung in dem einstellbaren Dämpfungsglied (22) festlegt.

## Revendications

1. Module de circuit intégré monolithique à micro-ondes (*Monolithic Microwave Inkegrated Circuit -* MMIC) (6 ; 48 ; 64) comprenant :
un plan de masse conducteur (15 ; 46 ; 62) ;
un circuit MMIC (10) sur ledit plan de masse (15 ; 46 ; 62) ;
un guide d'ondes (14 ; 52 ; 60) ; et
des connexions de signaux entre ledit guide d'ondes (14 ; 52 ; 60) et ledit circuit MMIC (10), dans lequel ledit guide d'ondes (14 ; 52 ; 60) possède une coupe transversale et s'étend dans le sens de la longueur sur ledit plan de masse (15 ; 46 ; 62), ledit guide d'ondes (14, 52, 60) comprenant une pluralité de variations de sa dimension de coupe transversale dans le sens de la longueur, la plus petite coupe (a) déterminant la fréquence de coupure du guide d'ondes sous laquelle les ondes électromagnétiques sont supprimées en amplitude, **caractérisé par**
un atténuateur réglable (22) positionné pour atténuer, dans une mesure réglable, les ondes électromagnétiques se propageant à travers ledit guide d'ondes (14 ; 52 ; 60).

2. Module selon la revendication 1, **caractérisé en ce que** ladite coupe transversale présente une forme rectangulaire.

3. Module selon l'une quelconque des revendications 1-2, **caractérisé en ce que** lesdites connexions de signaux comprennent en outre deux sondes (16, 18) positionnées pour coupler lesdites ondes électromagnétiques dans et en dehors dudit guide d'ondes (14 ; 52 ; 60), chaque sonde (16, 18) étant insérée dans ledit guide d'ondes (14 ; 52 ; 60) et possédant une longueur de pénétration et un emplacement déterminés avec précision afin de minimiser les pertes dues à l'insertion.

4. Module selon l'une quelconque des revendications 1-3, **caractérisé en ce que** lesdites variations de la coupe transversale dudit guide d'ondes (14 ; 52) comprennent une pluralité de transformateurs d'impédance à étape (20 ; 58), formés par des changements brutaux de la dimension de la coupe transversale le long de la dimension longitudinale dudit guide d'ondes (14 ; 52).

5. Module selon la revendication 4, **caractérisé en ce que** ledit guide d'ondes (14 ; 52 ; 60) est défini par un évidement (50 ; 66) dans le plan de masse (15 ; 46 ; 62) et un montage supérieur (12 ; 56) présentant un évidement, chacun desdits évidements possédant une pluralité de changements brutaux de leur profondeur afin de former ladite pluralité de transformateurs d'impédance à étape (20).

6. Module selon la revendication 4, **caractérisé en ce que** ledit guide d'ondes (52) est défini par un évidement (50) dans le plan de masse (46) et un montage supérieur (56) présentant un évidement (54), ledit évidement du plan de masse (50) possédant une profondeur sensiblement constante et ledit évidement du montage supérieur (54) possédant une pluralité de changements brutaux de la profondeur de l'évidement afin de former ladite pluralité de transformateurs d'impédance à étape (58).

7. Module selon l'une quelconque des revendications 1-3, **caractérisé en ce que** lesdites variations de la coupe transversale dudit guide d'ondes (60) comprennent des changements continus de la dimension de la coupe transversale.

8. Module selon la revendication 7, **caractérisé en ce que** ledit guide d'ondes (60) est défini par un évidement (66) dans le plan de masse (62) et un montage supérieur (68) présentant un évidement (70), ledit évidement du plan de masse (62) possédant une profondeur sensiblement constante et ledit évidement du montage supérieur (70) possédant des changements continus de la profondeur de l'évidement (70) afin de former lesdites variations de la coupe transversale.

9. Module selon la revendication 1, **caractérisé en ce que** ledit atténuateur réglable (22) comprend en outre une ouverture (24) dans ledit guide d'ondes (14 ; 52 ; 60), adaptée pour recevoir une carte résistive (26) qui est déplaçable afin de permettre une profondeur de pénétration variable de ladite carte (26) dans ledit guide d'ondes (14 ; 52 ; 60), moyennant quoi ladite profondeur de pénétration variable détermine la quantité d'atténuation dans ledit atténuateur réglable (22).
